# EUROPEAN PATENT APPLICATION

(11) **EP 2 048 710 A1**
(43) Date of publication of application: **15.04.2009**
(21) Application number: 08252405.9
(22) Date of filing: 15.07.2008
(51) Int. Cl.: H01L 21/98, H01L 21/60

(54) **High temperature packaging for semiconductor devices**

(30) Priority: 20.07.2007 US 780517
(71) Applicant: Pratt & Whitney Rocketdyne Inc., Canoga Park, CA 91309 (US)
(72) Inventor: Hertel, Thomas A., Santa Clarita California 91387 (US); Tan, Daniel, Walnut Calfornia 91789 (US)
(74) Representative: Leckey, David Herbert

(57) **Abstract**

A method of forming multiple bonds (20,22) on an electronic device (10) includes heating first bonding metals at a predetermined temperature to form a first bond (20) comprising a first melting temperature above the predetermined temperature. The first bond (20) and second bonding metals (32',34') are then heated at the predetermined temperature to form a second bond (22) comprising a second melting temperature above the predetermined temperature.

## Description

### BACKGROUND OF THE INVENTION

This invention relates to high temperature packaging for integrated circuits and, more particularly, to diffusion bonding for high temperature semiconductor devices.

Conventional integrated circuits utilize semiconductor devices having silicon base as a substrate for a semiconductor circuit. However, silicon has a drawback of having limited ability to withstand elevated temperatures without sustaining damage, which makes the integrated circuit vulnerable to failure at temperatures between 85°C and 125°C.

Other types of semiconductor devices may have better ability to withstand high temperatures by using a silicon carbide base instead of silicon. Although effective, the maximum operating temperature of the integrated circuit that uses the silicon carbide is still limited by the packaging of the semiconductor device. For example, the semiconductor can withstand temperatures above 250°C (482°F), but bonds that attach the semiconductor device to a substrate or electrical connections between the semiconductor device within the integrated circuit may be vulnerable to thermal fatigue type failure at such temperatures.

Accordingly, there is a need for a high temperature packaging solution for semiconductor devices that enables use at temperatures of about 300°C (572°F) or higher.

### SUMMARY OF THE INVENTION

An example method of forming multiple bonds on an electronic device includes heating first bonding metals at a predetermined temperature to form a first bond comprising a first melting temperature above the predetermined temperature, and heating the first bond and second bonding metals at the predetermined temperature to form a second bond comprising a second melting temperature above the predetermined temperature.

In one example, the method is used to manufacture an electronic device having multiple electronic components that are secured to at least one substrate. To secure the electronic components and the at least one substrate together, a plurality of metal layers are included between each electronic component. The metal layers are heated and diffuse together to form a bond having a desired composition that secures the electronic component and the at least one substrate together.

### BRIEF DESCRIPTION OF THE DRAWINGS

The various features and advantages of this invention will become apparent to those skilled in the art from the following detailed description of the currently preferred embodiment. The drawings that accompany the detailed description can be briefly described as follows.
Figure 1 illustrates an example electronic device.
Figure 2 illustrates an example step in forming the electronic device by diffusing a plurality of metal layers.
Figure 3 illustrates the electronic device after diffusing the metal layers to form a bond.
Figure 4 illustrates forming another bond without melting the bond that was previously formed.

### DETAILED DESCRIPTION OF THE PREFERRED EMBODIMENT

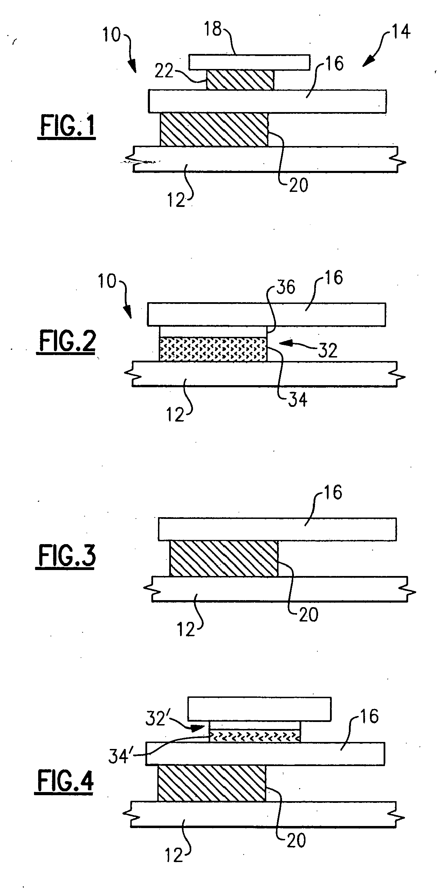

Figure 1 schematically illustrates selected portions of an example electronic device 10. In this example, the electronic device 10 includes a substrate 12 and a plurality of electronic components 14 mounted thereon. For example, the substrate 12 is a die pad and the electronic components 14 are semiconductor devices, such as those known as "wide-band gap" semiconductors and silicon carbide semiconductors. In the illustrated example, the plurality of electronic components 14 includes a first component 16 and a second component 18. In this example, the second component 18 is stacked on the first component 16, although in other examples the components 16 and 18 may be mounted side-by-side or in another desired configuration. A first bond 20 secures the first component 16 and the substrate 12 together, and a second bond 22 secures a second component 18 and the first component 16 together. In this regard, the first component 16 is a substrate for the second component 18.

The first bond 20 and the second bond 22 include an alloy that secures the respective components 16 and 18 in the desired positions on the substrate 12. The composition of the alloy may be selected from any of a variety of different suitable alloys, and may include a binary system (two metals) or a system including more than two different metals. In one example, the alloy includes a hypoeutectic composition of gold and tin. In a further example, the hypoeutectic composition comprises about 4-10 atomic percent (at%) of tin and a balance of gold. The term "about" as used in this description relative to composition refers to possible variation in the compositional percentage, such as normally accepted variations or tolerances in the art.

Using the hypoeutectic composition provides the benefit of allowing a "recursive" bonding process to be used to form the first bond 20 and the second bond 22. In other systems, compositions other than hypoeutectic, such as hypereutectic, may be used to achieve recursive bonding. Referring to Figure 2, the first bond 20 is formed from a plurality of layers 32 of bonding metals. Each of the layers 32 includes one metal that will be comprised in the desired composition of the alloy. For example, the layers 32 are deposited onto the first component 16 or onto the substrate 12 using vapor deposition, laser deposition, plasma deposition or other suitable deposition process.

The layers 32 are deposited in thicknesses that correspond to the desired composition of the first bond 20. In one example for forming an alloy of gold and tin, a gold layer 34 and a tin layer 36 are deposited in desired thicknesses. A ratio of the thickness of the gold layer 34 to the thickness of the tin layer 36 corresponds to the desired composition of gold and tin alloy in the final-formed first bond 20. Likewise, in other systems that utilize other metals or more than two types of metals, the thickness of the layers 32 corresponds to the desired composition of the selected alloy.

After deposition of the layers 32 onto the first component 16 or onto the substrate 12, the layers 32 are heated at a predetermined diffusion temperature, such as at a temperature near the eutectic temperature of the desired alloy. For example, the diffusion temperature is within about 80°C (176°F) of the eutectic temperature. In one example for a gold/tin system, the diffusion temperature is about 350°C (662°F). Heating at a diffusion temperature near the eutectic temperature causes the layers 32 to diffuse together to form the first bond 20, as shown in Figure 3. For example, during heating, a diffusion wave front moves through the thickness of the first bond 20 as the tin diffuses into solution with the gold to form the alloy of the first bond 20.

Upon diffusing and cooling, the composition of the formed alloy has a melting temperature that is greater than the diffusion temperature used to form the first bond 20. The higher melting temperature provides the benefit of allowing the first bond 20 to be heated to the diffusion temperature in a subsequent step to form the second bond 22, without melting the first bond 20. Thus, a plurality of such bonds can be "recursively" formed on the substrate 12 or on multiple sections of device without harming the bonds that were previously formed.

Referring to Figure 4, the first bond 20 and the second bond 22 are formed at the same diffusion temperature with the same alloy composition such that formation of the second bond 22 avoids melting or harming the previously formed first bond 20. The second bond 22 is formed similarly to the first bond 20. A plurality of layers 32' of second bonding metals are deposited onto the second component 18 or onto the first component 16 (substrate). For example, a gold layer 34' and a tin layer 36' are deposited and subsequently heated at the diffusion temperature as described above to diffuse the layers 32' together to form the alloy composition of the second bond 22. The plurality of layers 32' are heated at the diffusion temperature, which as described above is below the melting temperature of the alloy composition of the first bond 20.

For example, the diffusion temperature used for gold/tin is about 350°C (662°F), while the melting temperature of the example hypoeutectic composition (4-10 at% Sn, remainder Au) given above is about 498°C (928°F), which is more than 100°C (212°F) greater than the diffusion temperature. As can be appreciated, the electronic device 10 may include additional processes in addition to forming the bonds 20 and 22, such as but not limited to forming other types of bonds or electrical connections, or coating the components 16 and 18 and the bonds 20 and 22 with organic or inorganic dielectric coatings.

The alloy compositions of the first bond 20 and the second bond 22 are stable above 350°C (662°F) up to a temperature near 498°C (928°F). Thus, in combination with the high temperature capability of the components 16 and 18, the electronic device 10 can withstand operating temperatures beyond the limits of silicon based semiconductors and traditional solder bonded devices.

Although a combination of features is shown in the illustrated examples, not all of them need to be combined to realize the benefits of various embodiments of this disclosure. In other words, a system designed according to an embodiment of this disclosure will not necessarily include all of the features shown in any one of the Figures or all of the portions schematically shown in the Figures. Moreover, selected features of one example embodiment may be combined with selected features of other example embodiments.

The preceding description is exemplary rather than limiting in nature. Variations and modifications to the disclosed examples may become apparent to those skilled in the art that do not necessarily depart from the essence of this disclosure. The scope of legal protection given to this disclosure can only be determined by studying the following claims.

## Claims

1. A method of forming multiple bonds on an electronic device (10), comprising:
(a) heating first bonding metals at a predetermined temperature to form a first bond (20) comprising a first melting temperature above the predetermined temperature; and
(b) heating the first bond (20) and second bonding metals at the predetermined temperature to form a second bond (22) comprising a second melting temperature above the predetermined temperature.

2. The method as recited in claim 1, further comprising selecting the predetermined temperature to be within about 80°C of a eutectic temperature of an alloy of the first bonding metals, for example selecting the predetermined temperature to be about 350°C.

3. The method as recited in claim 1 or 2, further comprising diffusing the first bonding metals together in said step (a) to form the first bond (20) and diffusing the second bonding metals together in said step (b) to form the second bond (22).

4. The method as recited in claim 1, 2 or 3, further comprising forming the first bond (20) between a first silicon carbide semiconductor die and at least one substrate, and forming the second bond (22) between a second silicon carbide semiconductor die and the at least one substrate.

5. The method as recited in any preceding claim, further comprising depositing the first bonding metals in layers (32) having thicknesses that correspond to a desired composition of the first bond (20).

6. The method as recited in any of claims 1 to 5, further comprising depositing the first bonding metals in layers having thicknesses that correspond to a hypoeutectic composition of the first bond.

7. The method as recited in any preceding claim, further comprising depositing a gold layer (34) and a tin layer (36) such that heating at the predetermined temperature forms a gold/tin alloy.

8. An electronic device (10) comprising:
an electronic component (16);
a substrate (12); and
a plurality of metal layers (32) between the electronic component (16) and the substrate (12) for forming an alloy to bond the electronic component (16) and the substrate (12) together.

9. The electronic device as recited in claim 8, wherein the plurality of metal layers (32) comprise gold and tin.

10. The electronic device as recited in claim 8 or 9, wherein the electronic component comprises a silicon carbide semiconductor die.

11. The electronic device as recited in claim 8, 9 or 10, wherein the plurality of metal layers (32) comprises a gold layer (34) having a first thickness and a tin layer (36) having a second thickness, wherein a first thickness and the second thickness correspond to a desired composition of the alloy.

12. An electronic device (10) comprising:
a plurality of electronic components (16,18);
at least one substrate (12) attached to the plurality of electronic components (16,18); and
a diffusion bond (20,22) between each of the plurality of electronic components (16,18) and the at least one substrate (12), each diffusion bond (20) comprising an alloy.

13. The electronic device as recited in claim 12, wherein each of the plurality of electronic components (16,18) comprises a silicon carbide semiconductor die.

14. The electronic device as recited in claim 12 or 13, wherein the alloy comprises a hypoeutectic alloy including gold and tin.

15. The electronic device as recited in claim 11 or 14, wherein the alloy comprises about 4-10 at% of tin and a balance of gold.
